# EUROPEAN PATENT APPLICATION

(11) **EP 2 647 594 A2**
(43) Date of publication of application: **09.10.2013**
(21) Application number: 13152435.7
(22) Date of filing: 23.01.2013
(51) Int. Cl.: B81B 7/00

(54) **Methods and systems for limiting sensor motion**

(30) Priority: 05.04.2012 US 201213440931
(71) Applicant: Honeywell International, Inc., Morristown, NJ 07962-2245 (US)
(72) Inventor: Eskridge, Mark, Morristown, NJ New Jersey 07962-2245 (US)
(74) Representative: Houghton, Mark Phillip

(57) **Abstract**

System for limiting motion of a sensor assembly, in particular due to shocks. Stud bumps (110, 122) may be bonded to the base substrate (120), to the support ring (114), to the floating pad (50) or to the stop ring (52). The tud bumps create a shock cage between the spring-mounted pad (50) configured to receive the sensor device and the base substrate (120) or the stop ring (114).

## Description

### GOVERNMENT INTEREST

The invention described herein was made in the performance of work under U.S. Government Contract No. DE-EE0002754 titled Orientation Module 300 and sponsored by the Department of Energy. The Government may have rights to portions of this invention.

### BACKGROUND OF THE INVENTION

When mounting sensors, performance can be affected, due to stresses transmitted to the sensor device. Typically, isolators are used to reduce transmitted stresses. The effectiveness of an isolator can be limited by the requirements that it survive large deflections from the assembly process and shock and vibration during use. Often an isolator that is "softer" (more flexible) would do the best job of isolation, but might deflect too much during use and, thus, break.

### SUMMARY OF THE INVENTION

The present invention includes a method for setting small gaps (creating a shock "cage") utilizing commonly used stud bumps.

An exemplary isolator device includes a base substrate, a plurality of first metal stud bumps being bonded to the base substrate, a plurality of second metal stud bumps, and a support layer. The support layer includes a support ring, a floating raft configured to receive a sensor device and a plurality of springs. The support ring is bonded to the plurality of first metal stud bump. The floating raft is flexibly attached to the support ring via the springs. The plurality of second metal stud bumps is bonded to only one of the base substrate or the floating raft. The first and second metal stud bumps have a compressed height dimension. The compressed height dimension of the second metal stud bumps is less than the compressed height dimension of the first metal stud bumps.

In one aspect of the invention, the device further includes a stop ring having a hole with a width dimension, a plurality of third metal stud bumps being bonded to the support ring and a plurality of fourth metal stud bumps being bonded to only one of the floating raft or the stop ring. The third and fourth metal stud bumps have a compressed height dimension. The compressed height dimension of the fourth metal stud bumps is less than the compressed height dimension of the third metal stud bumps.

This invention uses only methods and structures already required by the process of die mounting to very accurately and repeatedly set stop gaps. It is highly automatable. It can be used to limit the stress seen by the isolator during die attachment or to cage the part completely for operation.

### BRIEF DESCRIPTION OF THE DRAWINGS

Preferred and alternative embodiments of the present invention are described in detail below with reference to the following drawings:

FIGURE 1 is a perspective view of a sensor package formed in accordance with an embodiment of the present invention;

FIGURES 2 and 3 are cross-sectional views of the package shown in FIGURE 1; and

FIGURES 4-1 through 4-8 are cross-sectional views of steps of an exemplary process for forming a sensor package in accordance with an embodiment of the present invention.

### DETAILED DESCRIPTION OF THE INVENTION

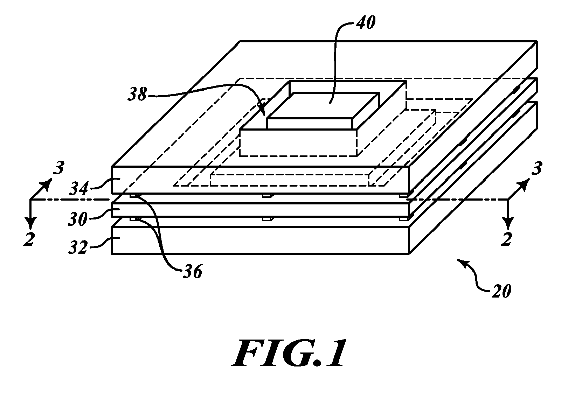

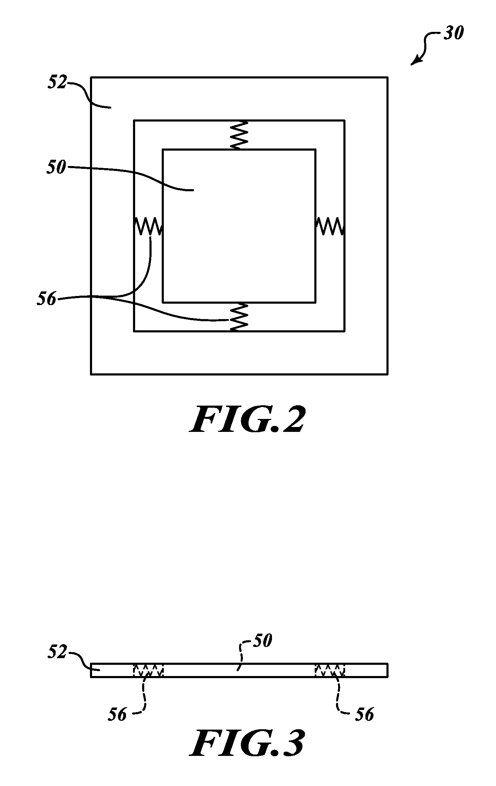

FIGURES 1-3 show a sensor package 20 formed in accordance with an embodiment of the present invention. The sensor package 20 includes an isolation layer 30, a sensor device 40 mounted to the isolation layer 30, and upper and lower substrate sections 32, 34 that are mounted to the isolation layer 30 using stud bump 36, such as gold stud bumps (GSBs) or physically comparable stud bumps. The upper substrate section (hereinafter "stop ring") 34 includes a hole 38 for receiving the sensor device 40 but not a raft 50 that is used to support the sensor device 40.

The isolator layer 30 includes a raft (a center isolation bond pad) 50 connected to a support structure (i.e., stop ring) 52 via springs 56 formed into the material of the isolation layer 30. Other support structures are possible, including multiple isolation bond pads or a support "ring" divided into many discrete sections. It is possible to form the isolator layer 30 from various metals, silicon, or glasses using appropriate techniques, such as machining (e.g., ultrasonic, bulk), sintering, electronic discharge machining (EDM), etching (e.g., acid for metals, reactive ion etch for silicon) and other techniques well understood by the various industries. In one embodiment, the isolator layer 30 is formed by a deep reactive ion etching (DRIE) process.

In one embodiment, the sections 32, 34 and the isolation layer 30 are enclosed within a ceramic, plastic, and/or alumina package that encloses and protects the sensor device 40.

The stop ring 34 is formed of any suitable material (e.g., metal, silicon, or glass). The inner hole 38 is smaller than the raft 50, thus allowing the stop ring 34 to interfere with undesired movements of the raft 50. In one embodiment, the stop ring includes fingers (not shown) that reach over the raft or the stop ring is formed using multiple separate pieces.

The sensor device 40 is any sensor requiring a firm mounting, which does not induce stress due to coefficient of thermal expansion (CTE) mismatch and external forces on the package 20. For example, the sensor device 40 is an accelerometer, a gyro, a pressure sensor, or other sensing device.

In one embodiment, the stud bumps 36 compress in proportion to force applied. The stud bumps 36 get progressively harder to compress as they are crushed and do provide a small spring-back force. The stud bumps 36 adhere to metallized portions of the various surfaces. Metallizations are not applied where there is a desire to not have surface-to-bump bonding.

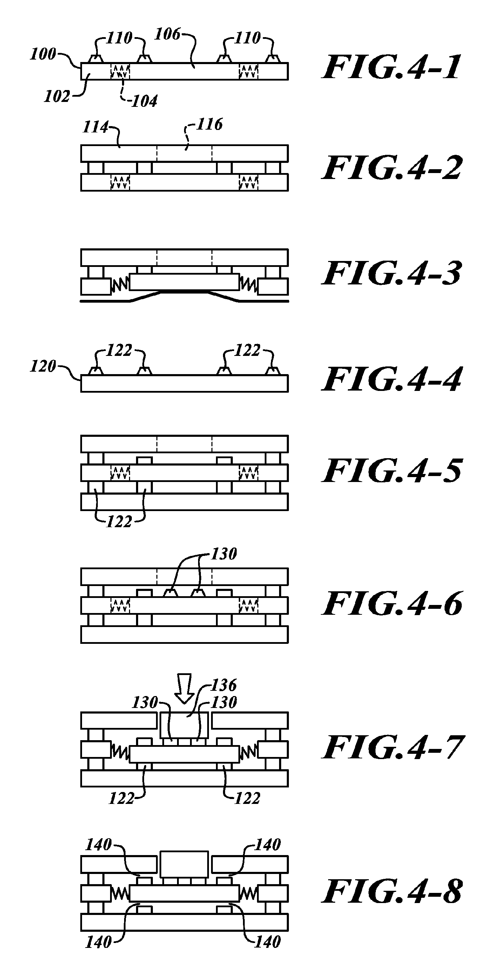

FIGURES 4-1 through 4-8 show steps of a process for making a sensor package, such as that shown in FIGURE 1. First, as shown in FIGURE 4-1, an isolation layer 100 is etched to form a support ring 102, springs 104, and a raft 106. Then, stud bumps 110 are bonded to the raft 106 and the support ring 102 using previously applied metallized pads. At this point, the stud bumps 110 are not compressed.

Next, as shown in FIGURE 4-2, a stop ring 114 having a hole 116 (previously etched/machined) is compressed to the stud bumps 110, thereby causing them to compress and causing the stud bumps 110 to bond to previously applied metallizations located on the support ring 102 and raft 106. Only the stud bumps 110 bonded to the support ring 102 bond to previously applied metallizations on the stop ring 114.

As shown in FIGURE 4-3, the raft 106 is further compressed into the stop ring 114, causing further compression of the raft stud bumps 110. This can be done a number of ways, such as flipping the assembly and applying a force only to the raft 106 or applying force to the stop ring 114 while the raft 106 makes contact with a pedestal (as shown).

As shown in FIGURE 4-4, stud bumps 122 are added to a base substrate 120 in order to match those on the isolation layer 100. The stud bumps 122 are added onto previously applied metallized pads.

As shown in FIGURE 4-5, the base substrate 120 is bonded to the isolation layer 100. Because of the spring 104, the stud bumps 122 that are under the support ring 102 become compressed. The raft 106 does not include any metallization on a bottom surface, thereby ensuring no bond occurs with the stud bumps 122.

Next, as shown in FIGURE 4-6, stud bumps 130 are applied to a top of the raft 106 through the hole 116 over previously applied metallized pad(s). In another embodiment, the bumps 130 are applied when the bumps 110 are applied or are attached to a mechanism (i.e., sensor) 136 before the mechanism 136 is attached to the raft 106.

As shown in FIGURE 4-7, a force is applied to the mechanism 136 located over the stud bumps 130 on top of the raft 106, thereby causing the mechanism 136 to bond to the stud bumps 130 while depressing the stud bumps 122 under the raft 106.

Then, as shown in FIGURE 4-8, after the force is released from the mechanism 136, the springs 104 cause the raft 106 to return to a null position. In the null position shock gaps 140 are formed between the raft 106 and the stud bumps 122 and between the stud bumps 122 on the raft 106 and the stop ring 114. The isolation raft 106 with the mechanism 136 floats in neutral position with small gaps 140 to limit movement due to shock/vibration, thereby preventing breakage of the springs 104 during excessive shock events.

In the case where no travel cage is required, the same concept is used to support floating parts of isolator ("rafts") during diebond so that delicate isolation springs do not break. In this example, steps 1, 2, and 3 (FIGURES 4-1 through 4-3) are skipped. Only the isolator is bonded to the substrate (no stop ring in this case). Force used to bond mechanism to isolation raft will compress bumps beneath. This will reduce the travel of the isolator during bonding so springs do not break, and after bond there will be a small gap between isolator and substrate.

The order of stud bumping and bonding of the bumps can be arranged differently than what is shown in the Figures.

The embodiments of the invention in which an exclusive property or privilege is claimed are defined as follows:

## Claims

1. An isolator device comprising:
a base substrate (120);
a plurality of first metal stud bumps (122) being bonded to the base substrate;
a plurality of second metal stud bumps (122); and
a support layer (30) comprising:
a support ring (52);
a floating raft (50) configured to receive a sensor device; and
a plurality of springs (56),
wherein the support ring is bonded to the plurality of first metal stud bumps,
wherein the floating raft is flexibly attached to the support ring via the springs,
wherein the plurality of second metal stud bumps is bonded to only one of the base substrate or the floating raft,
wherein the first and second metal stud bumps have a compressed height dimension,
wherein the compressed height dimension of the second metal stud bumps is less than the compressed height dimension of the first metal stud bumps.

2. The device of Claim 1, further comprising:
a stop ring (114) having a hole with a width dimension;
a plurality of third metal stud bumps (110) being bonded to the support ring; and
a plurality of fourth metal stud bumps (110) being bonded to only one of the floating raft or the stop ring,
wherein the third and fourth metal stud bumps have a compressed height dimension,
wherein the compressed height dimension of the fourth metal stud bumps is less than the compressed height dimension of the third metal stud bumps.

3. The device of Claim 2, wherein the floating raft has a width dimension, wherein the width dimension of the floating raft is greater than the width dimension of the hole of the stop ring.

4. The device of Claim 2, wherein the stop ring, the base substrate, and the support layer comprise silicon, further comprising metalized pads,
wherein the metalized pads are located where the metal stud bumps are bonded to the respective component.

5. A method of forming an isolator device comprising:
a) bonding a support ring (52) of a support layer (30) to a plurality of first metal stud bumps (122), wherein the support ring comprises a floating raft (50) configured to receive a sensor device and a plurality of springs (56), wherein the floating raft is flexibly attached to the support ring via the springs;
b) bonding a plurality of second metal stud bumps (122) to only one of a base substrate or the floating raft; and
c) compressing the first and second metal stud bumps based on a pressure applied between the floating raft and the base substrate,
wherein the compressed height dimension of the second metal stud bumps is less than the compressed height dimension of the first metal stud bumps.

6. The method of Claim 5, further comprising:
d) bonding a stop ring (114) having a hole with a width dimension to a plurality of third metal stud bumps (110); and
e) bonding a plurality of fourth metal stud bumps (110) to only one of the floating raft or the stop ring,
f) applying pressure between only the stop ring and the floating raft, thereby compressing the fourth metal stud bumps to a compressed height,
wherein the height dimension of the fourth metal stud bumps is less than the height dimension of the third metal stud bumps,
wherein d-f are performed before a-c.

7. The method of Claim 6, wherein the floating raft has a width dimension, wherein the width dimension of the floating raft is greater than the width dimension of the hole of the stop ring.

8. The method of Claim 6, wherein the stop ring, the base substrate, and the support layer comprise silicon,
wherein bonding the metalized pads comprises applying metalized layers to the respective components prior to application of the metal stud bumps.
